Europäisches Patentamt

European Patent Office

Office européen des brevets

(19)

(11) Publication number : **0 542 656 A1**

(12) **EUROPEAN PATENT APPLICATION**

(21) Application number : **92480138.4**

(22) Date of filing : **25.09.92**

(51) Int. Cl.⁵ : **B23K 26/00, H01L 21/48**

(30) Priority : **31.10.91 US 785630**

(43) Date of publication of application :
**19.05.93 Bulletin 93/20**

(84) Designated Contracting States :
**DE FR GB**

(71) Applicant : **International Business Machines Corporation**
**Old Orchard Road**
**Armonk, N.Y. 10504 (US)**

(72) Inventor : **Gambino, Jeffrey Peter**
**12 Webatuck Road**
**Gaylordsville, Connecticut 06755 (US)**
Inventor : **Knappenberger, Jay Rule**
**35 All Angels Hill Road**
**Wappingers Falls, New York 12590 (US)**
Inventor : **Natzle, Wesley Charles**
**112 Chelsea Way**
**Wappingers Falls, New York 12590 (US)**

(74) Representative : **Klein, Daniel Jacques Henri**
**Compagnie IBM France Département de Propriété Intellectuelle**
**F-06610 La Gaude (FR)**

(54) **Pattern propagation by blanket illumination of patterned thermal conductors and patterned thermal insulator on a thermal conductor.**

(57) A patterned film on a substrate (18) is transferred to an overlayer or an underlayer metallic film which absorbs laser light. Selective ablation of the metallic layer is produced by irradiating the structure using uniform, blanket or unpatterned illumination generated by a system including a laser (10). The process relies on laser heating of the overlayer or underlayer film where it is in contact with the thermal insulator to drive film ablation or chemical reaction. Regions in contact with a thermal conductor are of lower temperature and thus remain intact. The layer to be etched can be composed of one or several layers of different materials. The composite must be thin thermally and one layer of the composite absorbs a portion of the incident laser light. Laser energy is large enough so that the temperature increase caused by absorption is sufficient to drive the ablation or chemical etching reaction.

FIG. 1

SUBSTRATE 18

BEAM SCANNER 20

LENS 16

BEAM HOMOGENIZER 14

LENS 12

LASER 10

EP 0 542 656 A1

The present invention generally relates to the manufacture of patterned thin films, especially those made of metal, and, more particularly, to patterning of such films using uniform, blanket or unpatterned laser irradiation. The invention is especially useful in manufacturing a variety of micro-electronic devices.

Description of the Prior Art

It is well known to use a laser to selectively remove a metallized insulative substrate. See for example US-A-3 911 444 to Lou et al. which discloses scanning a laser beam over a metallized substrate. The laser beam is modulated to directly vaporize predetermined portions of the metallic coating, the remaining metal defining an electrical connecting pattern for printed wiring boards.

US-A- 4 081 653 to Koo et al. discloses a process for the removal of a thin coating of metal from an insulative substrate by laser induced explosion. The laser light is directed in a pattern so that selected portions of the thin metallic coating are heated to a temperature above the vaporization temperature of the substrate material but below the melting temperature of the thin film. The substrate becomes heated and portions of the substrate material at the thin film/substrate interface are vaporized, entrapping the vapors and inducing an explosion which removes the portions of the thin film coating from the substrate.

Processes such as that disclosed by Lou et al. and Koo et al. are particularly adapted to relatively large scale patterns. Lens design limitations suggest that resolution limits for direct laser processing will be greater or equal to that of resist based photolithography processing. As dimensions shrink, the same factors that challenge photolithography processing in the highest resolution applications also challenge direct laser processing.

It is also known in the prior art to use a uniform, blanket or unpatterned laser radiation for patterning of a material. For example, US-A- 4 615 904 to Ehrlich et al. discloses a process in which seed layers of a patterned metal are deposited on a substrate. Blanket illumination of a precursor molecule in the gas phase above the substrate releases metal atoms when exposed to light of the appropriate wavelength and results in growth of the seed layer. According to Ehrlich et al., metal atoms preferentially stick upon the metal seed layer.

Japanese Patent No. J59104287-A to Sumitomo Electric Co. describes etching of a substrate underneath a mask of patterned aluminum. The aluminum is reflective at the wavelength of incident light, whereas the material to be etched absorbs light. Heating of the material not covered with aluminum can induce ablation.

For the manufacture of future micro-electronic circuits, what will be advantageous is laser processing where a patterned layer can be produced on a substrate with an unpatterned laser.

**SUMMARY OF THE INVENTION**

It is therefore an object of the present invention to provide a process for transferring a pattern to a thin layer by uniform, blanket or unpatterned laser irradiation.

According to one aspect of the invention, the patterned layer is a layer of thermally conductive material. According to another aspect of the invention, the patterned layer is a layer of thermally insulating material. In the case of the patterned layer being a layer of thermally conductive material, the uniform illumination induces laser ablation of the material to be patterned that is not in contact with the thermal conductor. In the case of the patterned layer being a layer of thermally insulating material, uniform illumination induces laser ablation of material to be patterned that is not in contact with an underlying substrate that is a thermal conductor. In both cases, the absorption of similar amounts of light results in patterning upon uniform, blanket or unpatterned laser irradiation.

The layer to be etched can be composed of one or several layers of different materials. A composite of chromium (Cr) and copper (Cu) is used in a preferred embodiment of the invention. The composite must be thin thermally, and one layer of the composite absorbs a portion of the incident laser light. Laser energy is large enough so that the temperature increase caused by absorption is sufficient to drive the ablation or a chemical etching reaction.

The foregoing and other objects, aspects and advantages will be better understood from the following detailed description of a preferred embodiment of the invention with reference to the drawings, in which:

Figure 1 is a block diagram showing the preferred apparatus for performing the pattern propagation using either patterned thermal conductors or a patterned thermal insulator on a thermal conductor;

Figure 2 is a cross-sectional view of a substrate prepared with a patterned resist on a thin metallic film;

Figure 3 is a cross-sectional view similar to Figure 2 with the addition of an electroplated metal;

Figure 4 is a cross-sectional view similar to Figure 3 after the resist has been removed and the thin metallic film has been ion milled;

Figure 5 is a graph showing the spectral reflectance of certain metals;

Figure 6 is a cross-sectional view showing a thin metallic film applied over a patterned insulator; and

Figure 7 is a cross-sectional view similar to Figure 6 after blanket irradiation has ablated the thin metallic film from the patterned insulator.

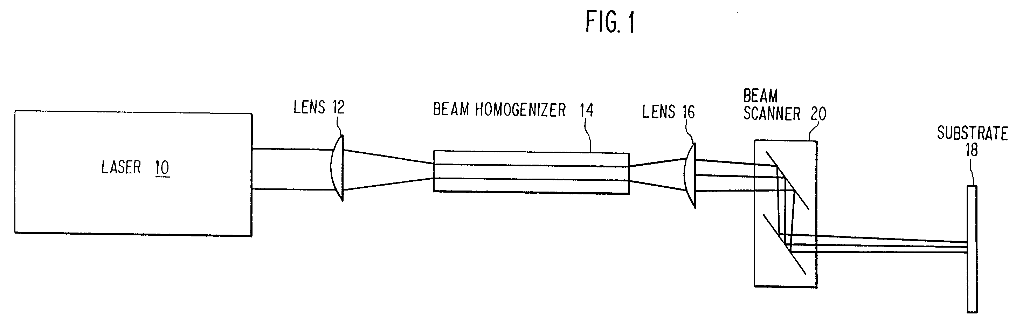

Referring now to the drawings, and more particularly to Figure 1, there is shown the preferred arrangement for uniform, blanket or unpatterned laser irradiation of a patterned substrate. Light from a laser 10 is focussed by lens 12 into a light tunnel beam homogenizer 14 that has a spatially uniform light intensity output. The output aperture of the light tunnel beam homogenizer 14 is re-imaged by lens 16 on the substrate 18, and the beam is scanned over the substrate 18 with a beam scanner 20 either before or after the imaging lens 16.

Any type of laser can be used. For some processing, a beam homogenizer may not be required. Homogenizers can be types other than a light tunnel.

## Illuminating a Patterned Thermal Conductor

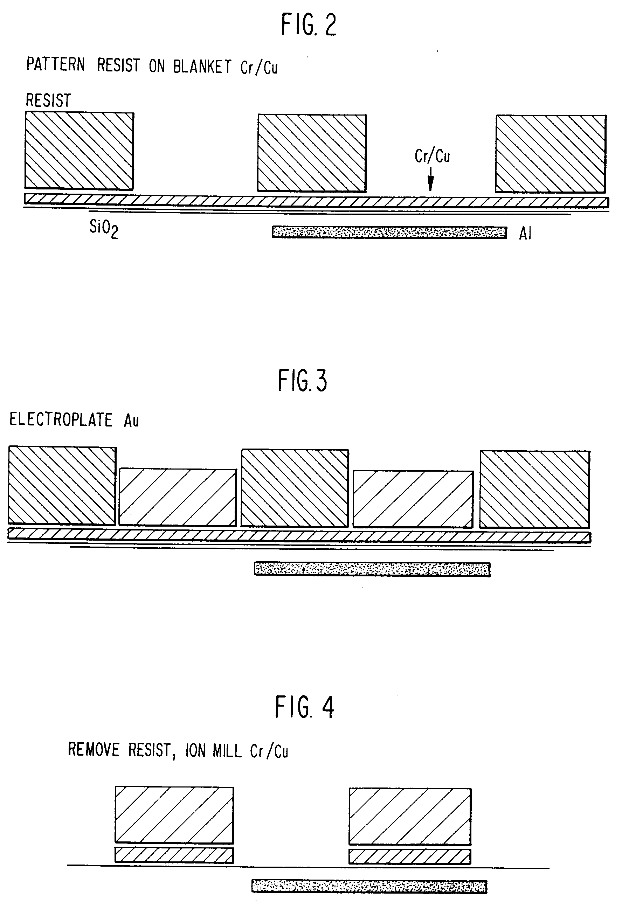

The use of a patterned thermal conductor in the practice of the invention will be illustrated by a specific example of the manufacture of a precision timing element (PTE). The PTE includes a buried Al layer within silicon dioxide ($SiO_2$) upon which a composite Cr/Cu layer is vacuum deposited, as generally shown in Figure 2. The Cr layer is about 0.03 $\mu$m thick and the Cu layer is about 1$\mu$m thick. A layer of patterned resist is placed on top of this blanket Cr/Cu layer. In Figure 3, gold (Au) is then electroplated on the exposed Cr/Cu layer, and in Figure 4, the resist is stripped and the whole substrate is ion milled. Milling of slightly more than 1$\mu$m of material produces a gold pattern with exposed $SiO_2$ because the Au is about 30$\mu$m thick and the Cr/Cu layer is only about 1$\mu$m thick. The Cr/Cu layer is milled away, and the Au is reduced in thickness to about 29$\mu$m.

The problem with this process is that the ion milling is very slow, with each substrate requiring more than forty-five minutes for processing. Also, heat generated in the substrate causes cracking of the $SiO_2$.

Blanket or unpatterned irradiation of the substrate from the front side with 2-4 J/cm$^2$ of 248nm light from a 30nsec KrF laser causes ablation of the Cr/Cu layer while leaving the Au intact. Since only one or two shots from the laser is required for Cr/Cu removal, a scanned 150W laser clears a several inch square substrate in much less than a minute. Au ablation essentially does not occur, with about 30Å removed under conditions where the Cr/Cu layer is ablated with one or two pulses. Experiments also show that the Cr/Cu layer is preferentially etched where not covered with Au with backside illumination of the structure, through the transparent $SiO_2$ substrate. With this geometry, only Cr (not Au or Cu) is illuminated.

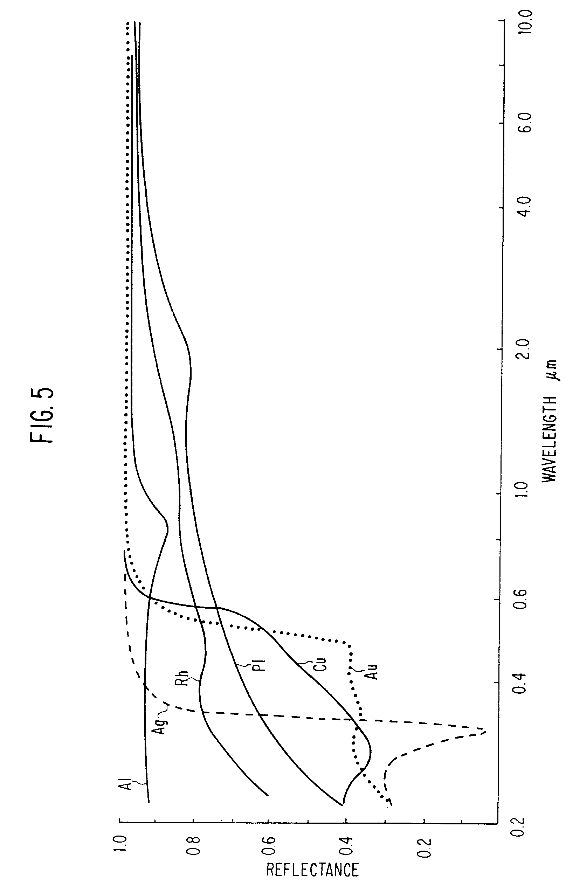

Figure 5 is a graph taken from page 154 of Physics Vade Mecam, H. L. Anderson, Ed., American Institute of Physics (1981), and shows that the reflectivity of Cu and Au are both about 35% near 248nm. Approximately 65% of the incident light is absorbed in the top few hundred angstroms of both the Cu and Au. During the laser pulse, the deposited energy begins to diffuse away from the surface.

In this section, the laser induced surface temperature jump at the surface of the Cu is estimated and compared to the surface temperature jump of the Au. It will be observed that the temperature of the Cu far exceeds the boiling point resulting in ablation while the temperature of the Au remains below the ablation temperature of the Au.

To determine temperatures, it is necessary to estimate the thickness of materials heated by the 30nsec laser pulse. Characteristic heat diffusion lengths are taken to be equal to one half the thickness which will reach 1/e times the original temperature when a slab is immersed in a cooler medium for the length of the laser pulse. The 1/e relaxation time for an infinite slab placed in a medium of fixed temperature is $t=4x^2/\pi^2/h^2$, where x is one half the thickness of the slab and $h^2$ is the thermal diffusivity. For a laser heated slab, the heat source is one side of the slab, so the thickness is reduced by a factor of two, and x is the thickness of the slab. t is set equal to the laser pulse length, and the equation is solved for x to estimate the thickness of material heated by the laser. Thus, the distance that the heat travels into the material during the laser pulse is proportional to the square root of the thermal diffusivity times the square root of the laser pulse length. Physics Vade Mecum, supra, gives a table on page 43 from which the thickness of material heated by 30nsec laser can be estimated.

Table 1 shows the thermal diffusivity of some relevant metals.

TABLE 1

| 248nm 30nsec 2J/cm² | Cu | Au | Al |
|---|---|---|---|
| Absorbed Energy J/cm² | 1.3 | 1.3 | 0.3 |
| Diffusivity cm²/sec | 1.1 | 1.2 | 0.8 |
| Thickness Heated μm | 3 | 3 | 2.5 |
| Heat Capacity J/cm³°K | 3.4 | 2.5 | 2.4 |
| $\Delta T$ | 3770 | 3140 | 835 |

$$T(\text{melt}) \text{ for Al} = 933°K \approx T_{Al}$$
$$T(BP) \text{ for Cu} = 2840°K \approx T_{Cu}$$
$$T(BP) \text{ for Au} = 3081°K \approx T_{Au}$$

The thermal diffusivity of quartz is around 120 times less than for Cu or Au, so heat flows into less than 0.3μm of the $SiO_2$ during the laser pulse. The behavior of the Cu and Au are very different from each other because of the difference in thickness. The 1μm thickness of the Cr/Cu layer is much less than the 3μm characteristic length of diffusion of heat within Cu during the 30nsec laser pulse. The thickness of the Au layer is much greater than the characteristic length of heat flow within Au. Thus, an approximation is made that the Au layer behaves like an infinitely thick piece of Au. The Cr/Cu layer acts like a thin layer of metal on a thermally insulating $SiO_2$ substrate. Thus, heat flow into the thermally insulating $SiO_2$ is ignored, and the layer of Cr/Cu on $SiO_2$ is approximated as an isolated, freestanding layer of metal in a vacuum.

Since the optical absorption coefficients of Cu and Au are about the same at 248nm, an incident fluence of 2J/cm² will result in an absorbed energy density, I, of about 1.3J/cm² for both the Cu and Au surface. The temperature increase for uniformly distributed heat within a free standing metal film is $I/\rho/C/x$, where I is the absorbed energy density, $\rho$ is the density, x is the layer thickness and C is the specific heat.

J. F. Ready in Effects of High Power Laser Irradiation, Academic Press (1981), gives the temperature at the surface of an infinitely thick layer heated by a laser; $(2I/K)(h^2/\pi/t)^{1/2}$, where I is the absorbed energy fluence, K is the thermal conductivity, $h^2$ is the thermal diffusivity, and t is the laser pulse length. For a thin, illuminated Cr/Cu layer on the $SiO_2$ thermal insulator, the temperature rise will be 3770°K, well above the temperature required for ablation. for a thick, gold thermal conductor, the temperature increase is 3140°K, near the boiling point, but below the temperature for ablation. For a thin (<<3μm) illuminated Cu layer on top of a gold thermal conductor, the temperature increase is also about 3140°K because the optical absorption coëfficient is about the same for Cu as for Au, and the deposited heat is quickly transferred to the thick underlying gold layer. The laser strikes the Cr portion of the Cr/Cu layer when illuminated from the backside, through the $SiO_2$ substrate. The portion not in contact with the patterned Au layer reaches a much higher temperature than the portion in contact with Au and is therefore ablated.

Requirements for laser patterning by blanket or unpatterned irradiation of a patterned thermal conductor include a layer to be etched by either ablation/evaporation or by chemical etching by an included bath gas, a patterned overlayer or underlayer that is a relatively good thermal conductor, and a substrate that is a relatively poor thermal conductor. The layer to be etched should have a thickness considerably less than the thickness that heat flows during the laser pulse. The exact thickness is determined by the thermal properties of the layer and by the laser pulse length. If the layer to be etched is between the laser and the patterned thermal conductor, then preferential etching is driven solely by the temperature differences arising from contact with the thermal conductor. If the patterned thermal conductor is between the laser and the layer to be etched, then etch rate differences can be driven by temperature differences or by some combination of temperature differences and inherent susceptibility to ablation or chemical etching.

Another potential application is cladding of lines of one material with another material. For instance, aluminum lines can be clad with copper by this method. Etching of Cu on $SiO_2$ occurs if thick Al lines on the $SiO_2$ are coated with a blanket layer of Cu, chlorine ($Cl_2$) is introduced as the bath gas and the substrate is irradiated with an ultraviolet (UV) laser.

Illuminating a Patterned Thermal Insulator

The use of a patterned thermal insulator in the practice of the invention will be illustrated by a specific example of the manufacture of contacts on an integrated circuit product. The contacts for the product consist of a self-aligned silicide, such as a silicide of colbalt, titanium, or platinum ($CoSi_2$, $TiSi_2$, or $PtSi$), underneath a diffusion barrier, such as titanium nitride (TiN), a composite of titanium and chromium (Ti/Cr), or tungsten (W). The silicide lowers the series resistance of the device and the diffusion barrier prevents Al or Cu from reacting with the underlying silicon (Si). The silicides are formed by depositing the appropriate metal, annealing to react the Si in the contact with the metal to form a silicide, and finally wet etching with a solution that removes the unreacted metal on the oxide, but not the silicide on the contacts. The diffusion barriers are formed by depositing the appropriate metal, and patterning using lithography.

There are a number of problems with the self-aligned silicide process. Devise yields can be decreased, due to excessive consumption of Si during the metal-Si reaction (which can cause junction leakage) or due to excessive lateral silicide formation (which can cause short circuits between closely spaced contacts). Finally, there are relatively few metals that can be used for a self-aligned silicide process, because of problems with the metal-Si reaction or with the wet etch step. For example, there is no self-aligned process for materials that are good diffusion barriers such as TiN or Ti/Cr. The advantages of self-aligned silicides are that they require no additional lithography and they occupy less area than contacts that are defined by lithography, resulting in higher circuit densities. The diffusion barriers at present have to be patterned using lithography resulting in additional processing and lower circuit densities.

One approach is to use selective tungsten CVD (chemical vapor deposition) to fill the contact; however, this chemical system is prone to production of "wormholes" and encroachment. Wormholes are probably small particles of $WSi_2$ that catalyze the decomposition of Si to some sort of fluorosilane in the presence of $WF_6$ and hydrogen. These small particles can burrow into the Si and short out the device. Encroachment is a decomposition of the $Si/SiO_2$ interface caused by the $WF_6/H_2$ mixture or the HF reaction products.

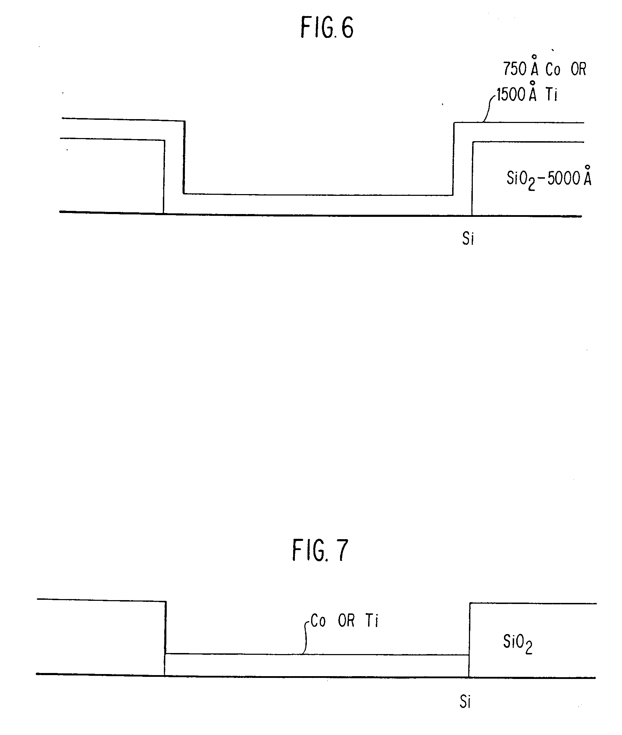

Using the invention, self-aligned metal contacts can be formed to lower the series resistance of the device and/or to act as diffusion barriers. An example is shown in Figure 6, where a Si substrate is prepared with a 750Å layer of Co or a 1500Å layer of Ti and subjected to blanket or unpatterned laser irradiation. Blanket or unpatterned irradiation of the substrate with 2-4 $J/cm^2$ of 248nm light from a 30nsec KrF laser causes ablation of the Ti or Co layer on field oxide while leaving metal in the contacts, as shown in Figure 7.

The blanket metal has the same optical absorption coefficient over the entire surface, and the same amount of energy is deposited upon the entire surface. Differences in behavior of the blanket metal layer arise from thermal differences in the underlying substrate. Once again, the distance that heat flows during the laser pulse can be estimated from the thermal diffusivity of quartz, silicon and metals.

The thermal diffusivity of quartz is about 0.009 $cm^2$/sec., and most solid pure metals have a thermal diffusivity greater than 0.2 $cm^2$/sec., and the thermal diffusivity of silicon is 0.9 $cm^2$/sec. These correspond to thicknesses of 0.26$\mu$m, 1.2$\mu$m and 2.6$\mu$m. So the silicon is a good thermal heat sink. The silicon dioxide/nitride thickness of around 0.5$\mu$m will act as a thermal insulator, and the very thin metal layer is an antennae which absorbs energy from the laser and transmits it very rapidly to the underlying substrate.

By patterning the thermal insulator, large temperature differences will form between metal on silicon compared to metal on silicon dioxide. Since I is the same over the whole illuminated surface, T(oxide)/T(silicon) is h(oxide)K(silicon) over h(silicon)K(oxide). Or T(oxide) = 7.6T(silicon). The temperature jump on thick oxide or nitride will be almost eight times greater than for the jump on silicon. This temperature difference drives ablation or removal of metal on oxide or nitride while metal on silicon is retained.

Neither Co nor Ti are as cleanly ablated as $SiO_2$/Cr/Cu. Perhaps the heated Co or Ti form oxides which impede the evaporation of the metal, or perhaps the Cr underlayer strongly interacts with the $SiO_2$ to prevent beading of the overlayer metal during evaporation.

Requirements for laser patterning by blanket or unpatterned irradiation of a patterned thermal insulator include a thermally thin layer (Co or Ti in the example) to be removed or etched by either ablation/evaporation or by chemical etching by an included bath gas, a patterned underlayer that is a thermal insulator, a substrate or another thick layer that is a thermal conductor (Si in the example but may be, for example, diamond).

While the invention has been described in terms of a two preferred embodiments, those skilled in the art will recognize that the invention can be practiced with modification within the spirit and scope of the appended claims. For example, types of lasers operating at other wavelengths such as $CO_2$, YAG or excimer lasers will be useful for processing other films, including non-metallic films, without damaging underlying structures. Also, as pattern dimensions shrink, lasers with shorter pulses, such as picosecond or femptosecond time-scale lasers will be come increasingly important.

## Claims

1. A method of forming a pattern in a layer of a material upon a substrate comprising the steps of:
   a) forming a first layer of at least one material to be patterned on said substrate;
   b) depositing a patterned second layer of at least one material either above or below said first layer, said second layer having a different thermal conductivity than said substrate and said first layer having a thickness and composition such that a substantial amount of heat imparted to said first layer by an illuminating laser pulse completely flows through said first layer during the laser pulse, and wherein any region of the second layer illuminated by a laser pulse is less reflective than the first layer; and,
   c) irradiating said substrate by a pulse of unpatterned laser illumination to cause removal of said first layer according to the pattern of said second layer.

2. The method recited in claim 1 wherein step b) now consists of :
   depositing a patterned second layer of at least one material either above or below said first layer, said second layer having a different thermal conductivity than said substrate and said first layer having a thickness such that a substantial amount of heat imparted to the first layer by an illuminating laser pulse completely flows through the first layer during the laser pulse, said first layer being between a source of said illuminating laser pulse and said second layer;

3. The method recited in claim 1 or 2 wherein said first layer to be patterned is comprised of a metal and said substrate is an insulator.

4. The method recited in claim 3 wherein said first layer is a composite layer containing Cr and said substrate is $SiO_2$.

5. The method recited in claim 4 wherein said second layer is Au having a thickness approximately an order of magnitude greater than the thickness of said composite layer.

6. The method recited in claim 3 wherein said second layer is a relatively good thermal conductor selected from the group consisting of Au, Si, Al and Cu.

7. The method recited in claim 6 wherein said substrate is a relatively poor thermal conductor selected from the group consisting of $SiO_2$ and $Si_3N_4$.

8. The method recited in claim 7 wherein said first layer is selected from the group consisting of Ti, Co, Cr and a composite of Cr/Cu.

9. The method recited in claim 1 or 2 wherein said second layer is between a source of said laser illumination and said first layer.

10. The method recited in claim 9 wherein said substrate is transparent to said laser illumination and said laser illumination is through said substrate.

11. The method recited in claim 1 or 2 further comprising the step of introducing a bath gas which preferentially reacts with said first layer, etching of said first layer being driven by a combination of temperature differences in exposed surfaces of said first layer and chemical etching by said gas.

12. The method recited in claim 1 or 2 wherein said second layer is composed of a material that is a relatively poor thermal conductor and said substrate is a relatively good thermal conductor.

13. The method recited in claim 12 wherein said first layer is selected from the group consisting of Co and Ti and said second layer is $SiO_2$.

14. The method recited in claim 12 further comprising the step of introducing a bath gas which preferentially reacts with said first layer, etching of said first layer being driven by a combination of temperature differences in surface areas of said first layer and chemical etching by said gas.

FIG. 1

EP 0 542 656 A1

# FIG. 2

PATTERN RESIST ON BLANKET Cr/Cu

RESIST

Cr/Cu

SiO2

Al

# FIG.3

ELECTROPLATE Au

# FIG. 4

REMOVE RESIST, ION MILL Cr/Cu

FIG. 5

## FIG. 6

750 Å Co OR
1500 Å Ti

SiO₂-5000 Å

Si

## FIG. 7

Co OR Ti

SiO₂

Si

# EP 0 542 656 A1

## European Patent Office

## EUROPEAN SEARCH REPORT

Application Number

EP 92 48 0138

### DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X<br>A | US-A-4 786 358 (YAMAZAKI ET AL.)<br>* column 2, line 25 - column 5, line 20; figures 1,3A-4E * | 1,2<br>9-14 | B23K26/00<br>H01L21/48 |
| A | US-A-5 012 067 (SATO ET AL.)<br>* claims 1,4; figure * | 1,5,6 | |
| A | US-A-4 498 951 (TAMURA ET AL.)<br>* column 4, line 33 - column 5, line 65; figures 2-3B * | 1,4,7 | |
| | | | **TECHNICAL FIELDS SEARCHED (Int. Cl.5)**<br><br>H01L<br>B23K |

The present search report has been drawn up for all claims

| Place of search | Date of completion of the search | Examiner |
|---|---|---|
| THE HAGUE | 02 MARCH 1993 | HERBRETEAU D. |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P0401)